# EUROPEAN PATENT APPLICATION

(11) **EP 4 164 349 A1**
(43) Date of publication of application: **12.04.2023**
(21) Application number: 21201231.4
(22) Date of filing: 06.10.2021
(51) Int. Cl.: H05K 7/20, H02K 11/33

(54) **CONTROL DEVICE FOR AN ELECTRIC MACHINE**

(71) Applicant: MAHLE International GmbH, 70376 Stuttgart (DE)
(72) Inventor: BOZIC, Jernej, 5250 Solkan (SI); BUCIK, Silvan, 5250 Solkan (SI); STOLFA, Danijel, 5250 Solkan (SI); VERDEV, Luka, 3320 Velenje (SI)
(74) Representative: BRP Renaud & Partner mbB Rechtsanwälte Patentanwälte Steuerberater

(57) **Abstract**

The invention relates to a control device (1) for an electrical machine. The control device (1) comprises a housing (2) partially surrounding a housing interior (3). The housing (2) comprises a lower housing part (4) made of metal, preferably of aluminum, and with an upper housing part (5) made of plastic. A printed circuit board (6) is arranged in the housing interior (3) between the housing lower part (4) and the housing upper part (5), on whose upper side (7) facing the housing upper part (5) at least one electrical/electronic power transistor (8) for supplying the electrical machine with electrical energy is arranged, which generates waste heat during operation. According to the invention, a biasing element (10) is arranged between the at least one power transistor (8) and the upper housing part (5), which biases the power transistor (8) against the lower housing part (4) to form a thermal contact.

## Description

The invention relates to a control device for an electric machine and to an electric machine having such a control device.

Electric machines usually comprise a rotor and a stator which interact electromagnetically with each other. To drive the rotor, the stator is energized with an alternating electric current, the so-called three-phase current. To generate the three-phase current, a control device is required that includes power transistors. Such power transistors generate waste heat during operation, which must be dissipated by the control device in order to prevent or at least counteract overheating of the power transistors.

Such control devices are known, for example, from EP 2023389 A2 and US 2008 278918A1.

However, conventional control devices with a corresponding heat dissipation are generally of relatively complicated design and thus involve a relatively complex assembly.

It is therefore an object of the present invention to provide an improved embodiment for a control device for an electrical machine, which is characterized by improved heat dissipation and, at the same time, a simple technical structure.

This object is solved by the object of the independent patent claims. Preferred embodiments are the subject matter of the dependent patent claims.

Accordingly, the basic idea of the invention is to equip a control device for an electrical machine with a two-part housing which comprises a lower housing part made of a metal and an upper housing part made of a plastic. Thus, a printed circuit board on which power transistors for generating an electric current are arranged can be arranged in the housing interior space bounded by these two housing parts. According to the invention, at least one biasing element is arranged in the housing interior between at least one power transistor and the upper housing part, which biases the power transistors arranged on the printed circuit board and thus the entire printed circuit board towards the lower housing part. In this way, particularly good thermal contact is achieved between the power transistor arranged on the printed circuit board and the lower metal housing part. In this way, the waste heat generated by the power transistors during operation, i.e. when electrically energized, can be effectively dissipated to the metal lower housing part, where it is passed on to the external environment of the control device. In this way, heat is effectively dissipated from the power transistor. At the same time, the structure presented above is technically relatively simple. Thus, the control device can also be assembled in a relatively simple manner.

A control device for an electrical machine according to the invention comprises a housing which partially surrounds a housing interior. The housing comprises a lower housing part made of metal, preferably of aluminum, and an upper housing part made of a plastic. A printed circuit board is arranged in the housing interior between the housing lower part and the housing upper part. At least one electrical or/and electronic power transistor for supplying the electrical machine with electrical energy is arranged on the upper side of the printed circuit board facing the upper part of the housing. The power transistor generates waste heat during operation. The power transistor may be a MOSFET. According to the invention, a biasing element is arranged between the at least one power transistor and the upper housing part. According to the invention, the biasing element biases the power transistor against the lower housing part to form an improved thermal contact between the power transistor and the lower housing part. In this way, the waste heat generated by the power transistor can be effectively dissipated via the circuit board to the metallic lower housing part and from there to the external environment of the housing.

According to an advantageous further development, the control device comprises at least two, preferably several, power transistors. In this further embodiment, a biasing element associated with each electrical power transistor is provided. In this way, improved thermal contact with the lower part of the housing is realized for all power transistors present on the printed circuit board.

Particularly expediently, the biasing element comprises or is a leaf spring with a geometry that is U-shaped in profile. In this case, a first U leg of the U-shaped profile is supported on the upper housing part. A second leg of the U-shaped profile is supported on the power transistor. A biasing element configured in this way has a particularly simple technical structure and is therefore inexpensive to manufacture.

According to an advantageous further development, a receptacle is formed for each biasing element on an underside of the upper part of the housing facing the printed circuit board. The biasing element is at least partially received in the receptacle, preferably at least with the first U-leg. The receptacle can particularly preferably be formed as a recess. Such a receptacle or recess is technically particularly easy to manufacture and ensures secure fixing of the pretensioning element to the upper part of the housing, even in the pretensioned state. In addition, such a preloading element can be preassembled particularly easily in such a receptacle or recess during assembly of the control device.

According to an advantageous further development, the upper housing part is configured as a housing frame with a, preferably annular, circumferential wall and with a support structure on the end face. In this further development, the support structure is open and comprises two strut-like support elements. The support elements connect two circumferential wall sections of the circumferential wall, which are arranged at a distance from one another, preferably opposite one another. In this further embodiment, the at least one biasing element, preferably its first U-leg, is supported on one of the support elements. Such a design of the upper part of the housing as an open housing frame enables the worker, even in the assembled state of the printed circuit board between the lower part of the housing and the upper part of the housing, to have direct access to those electrical and electronic components arranged on the printed circuit board which are not covered by the support structure in a top view of the upper part of the housing. In particular, said components can be electrically wired in a simple manner due to their accessibility.

According to a preferred embodiment, the two support elements may cross each other. Alternatively or additionally, in this measure the two support elements may be arranged at an angle, preferably at a right angle, to each other. Alternatively or additionally, in this measure, the two support elements may have the geometry of a cross, preferably with a 90° rotational symmetry. Alternatively or additionally, in this measure, the two support elements and the circumferential wall may be integrally formed on each other. All of the above-mentioned variants result in mechanical stiffening of the upper part of the housing. This applies in particular if the upper housing part is an injection-molded plastic injection-molded part.

According to a preferred embodiment, the above-mentioned at least one receptacle or recess for receiving a biasing element is arranged on the strut-like support element.

In an advantageous further embodiment, an additional printed circuit board with at least one electronic logic component for controlling the at least one power transistor is arranged on an upper side of the housing upper part facing away from the printed circuit board. For this purpose, the at least one logic component can be electrically connected to at least one power transistor arranged on the printed circuit board. The logic component may be realized as an integrated circuit (IC). Particularly preferably, the additional printed circuit board is arranged on the support structure of the upper part of the housing. In this way, electrical and electronic components which are particularly sensitive to heat can be arranged in a confined space at a distance from the power transistors which generate waste heat. The design of the upper part of the housing with strut-like support elements enables simple mounting of the additional printed circuit board on the upper side of the support structure or upper part of the housing facing away from the printed circuit board with the power transistors.

According to a further advantageous further development, a rib structure with at least two support ribs projecting from the upper side is formed on an upper side of the lower housing part facing the printed circuit board. In this further embodiment, the support ribs are in contact with the underside of the printed circuit board at least in a contact zone in which the at least one power transistor, preferably all power transistors, is/are arranged on the upper side of the printed circuit board. As a result, a mechanical counterpressure is exerted on the biased power transistor, which improves the thermal contact of the at least one power transistor with the lower part of the housing.

Particularly preferably, a heat-conducting layer is arranged between the printed circuit board and the rib structure, at least in the region of the contact zone, for thermal coupling of the printed circuit board with the power transistor to the lower part of the housing. This measure also enhances the thermal contact of the at least one power transistor with the lower housing part.

Particularly preferably, the support structure and the rib structure have substantially the same geometric shape in a top view of the upper housing part and the lower housing part, respectively. As a result, the printed circuit board can be clamped between the upper housing part and the lower housing part in the region of the at least one power transistor, whereby - due to the contact pressure achieved on the printed circuit board - a particularly good thermal contact of the power transistor with the lower housing part can be achieved.

Particularly expediently, the printed circuit board can be sandwiched between the rib structure formed on the lower part of the housing and the support structure formed on the upper part of the housing. This variant enables a particularly effective arrangement of the printed circuit board and thus of the power transistors arranged on the printed circuit board to the lower housing part. At the same time, this variant requires little installation space in the axial direction.

According to a further advantageous further development at least one electrical power terminal and/or at least one electrical control terminal interface is arranged on the circumferential wall. In this way the lower housing part can be provided with cooling pins over the whole axial facing surface as it does not need to accommodate any terminals. The cooling of the transistors is therefore more efficient. Moreover, the axial length of the control device with connecting terminals can also be thereby reduced.

The invention further relates to an electrical machine having a stator and having a rotor which is rotatable relative to the stator. For driving the rotor, the machine further comprises a control device according to the invention presented above, so that the advantages of the control device according to the invention explained above are transferred to the electric machine according to the invention.

Further important features and advantages of the invention will be apparent from the subclaims, from the drawings and from the accompanying figure description based on the drawings.

It is understood that the above features, and those to be explained below, can be used not only in the combination indicated in each case, but also in other combinations or on their own, without departing from the scope of the present invention.

Preferred embodiments of the invention are shown in the drawings and will be explained in more detail in the following description, wherein identical reference signs refer to identical or similar or functionally identical components.

The following are shown, each schematically
- Fig. 1:: an example of a control device according to the invention in perspective view,
- Fig. 2: a separate perspective view of a biasing element in the form of a leaf spring of the control device of Fig. 1,
- Fig. 3: a perspective view of the upper part of the housing of the control device of Fig. 1,
- Fig. 4: a sectional view of the control device in the region of the lower housing part and upper housing part,
- Fig. 5: a perspective view of the printed circuit board with the lower housing part.

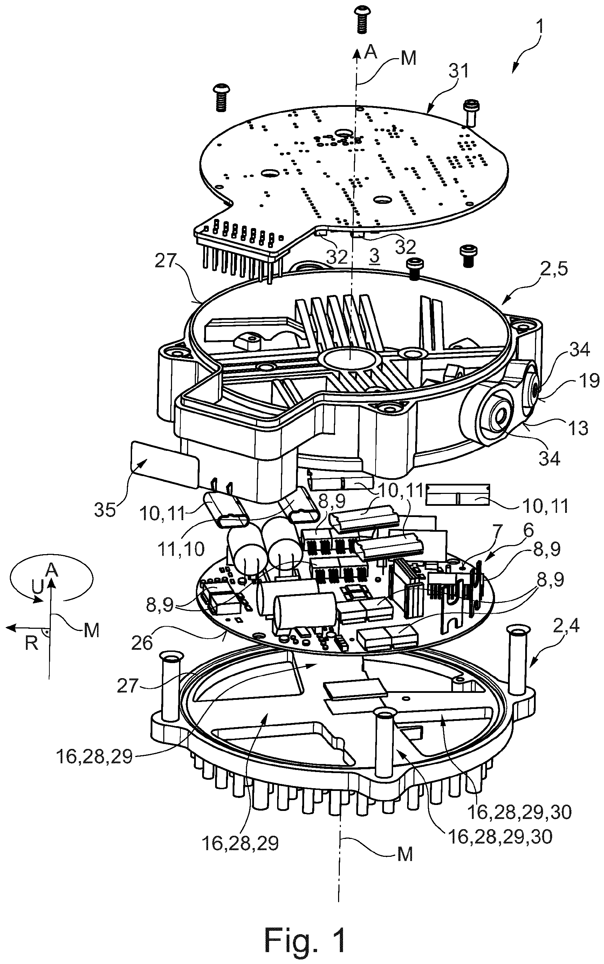

Figure 1 illustrates in an exploded view an example of a control device 1 for an electrical machine (not shown). According to Figure 1, the control device 1 comprises a housing 2 partially surrounding a housing interior 3. The entire housing 2 has a cylindrical geometric shape and has a central longitudinal axis M extending along an axial direction A. A radial direction R extends perpendicular to the axial direction A away from the central longitudinal axis M. A circumferential direction U circumambulates the central longitudinal axis M perpendicular to both the axial direction A and the radial direction R.

The housing 2 comprises a lower housing part 4 made of metal, in the example of aluminum, and an upper housing part 5 made of a plastic. A printed circuit board 6 is arranged in the housing interior 3 in the axial direction A between the housing lower part 4 and the housing upper part 5. A plurality of power transistors 8 in the form of MOSFETs 9 are arranged on an upper side 7 of the printed circuit board 6 facing the upper housing part 5 axially. The power transistors 8 or MOSFETs 9 are used for controllably supplying the electrical machine with electrical energy in order to drive the rotor of the machine in this way. The power transistors 8 or MOSFETs 9 generate waste heat during operation. A biasing element 10 is arranged axially between each power transistor 8 and the upper housing part 5. The biasing element 10 biases the associated power transistor 8 axially against the lower housing part 4 to form a thermal connection between the power transistor 8 and the lower housing part 4.

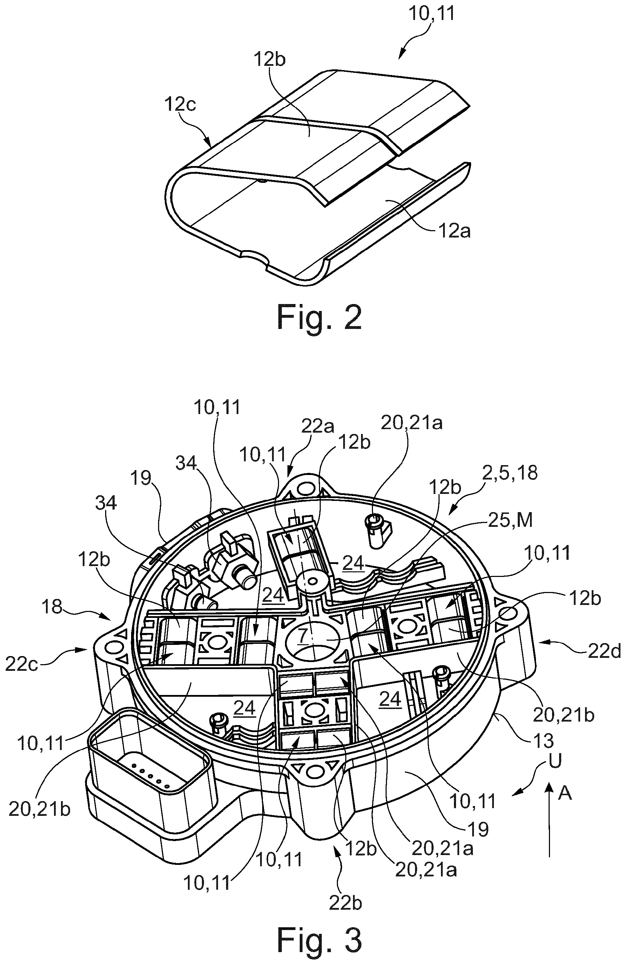

Figure 2 shows the biasing element 10 in separate perspective view. Accordingly, the biasing element 10 can be configured as a leaf spring 11 with a geometry that is U-shaped in profile. The biasing element 10 thus comprises a first U-leg 12a and a second U-leg 12b, which merge into one another in the region of a U-base 12c.

Figure 3 shows the upper housing part 5 in a separate perspective view, in which its underside 13 can be seen. According to Figure 3, the upper housing part 5 can be configured as a housing frame 18 with a circumferential wall 19 extending along the circumferential direction U and with an axially frontal support structure 20. The support structure 20 is thus arranged in a plane extending perpendicular to the axial direction A. The support structure 20 comprises two respective strut-like support elements 21a, 21b, which in the example of figure 3 are arranged at substantially right angles to one another in a plan view along the axial direction A. Four through openings 24 are formed between the two support elements 21a, 21b and the peripheral wall 19. Each of the two supporting members 21a, 21b connects two circumferential wall portions 22a, 22b, and 22c, 22d, respectively, of the circumferential wall 19 which are opposite to each other.

In a top view of the upper housing member 5 along the axial direction A, the two supporting members 21a, 12b cross each other and are arranged at a substantially right angle to each other. Thus, the two support elements form a cross. A center 25 of the cross may be arranged on the central longitudinal axis M. The circumferential wall 19 and the two support elements 21a, 21b of the support structure 20 may be integrally formed on each other, i.e. the circumferential wall 19 and the support elements 21a, 21b may be formed in one piece and of the same material.

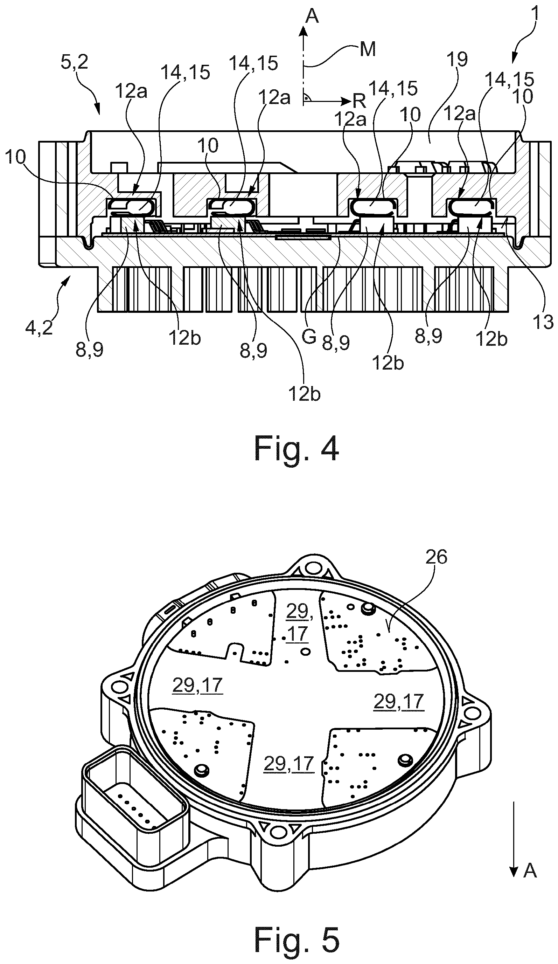

Figure 4 shows a sectional view of the control device 1 in the region of the lower housing part 4 and the upper housing part 5.

According to figure 4, for each biasing element 10, a receptacle 14 in the form of a recess 15 is formed on an underside 13 of the upper housing part 5 facing the printed circuit board 6. In the example scenario, the receptacles 14 or recesses 15 are distributed over the two support elements 21a, 21b (cf. figure 3). In each receptacle 14 or recess 15, one of the biasing elements 10 is received at least with the first U-leg 12a, so that it can support itself with this first U-leg 12a on the support element 21a or 21b.

As shown in Figures 3 and 4, the first U-leg 12a of the biasing elements 10, which are configured as leaf springs 11, is supported on one of the two support elements 21a, 21b of the support structure 20, respectively (cf. Figure 3). The second U-leg 12b of the same leaf spring 11 is supported on the associated power transistor 8 (cf. Figures 3 and 4).

Now referring again to Figure 1, a plurality of support ribs 28 projecting from the upper surface 27 of the lower housing portion 4 are formed on an upper surface 27 of the lower housing portion 4 facing the printed circuit board 6. The support ribs 28 form a rib structure 16 and abut the lower side 26 of the printed circuit board 6 in a lateral contact zone 29, in which contact zone 29 the power transistors 8 are also arranged on the upper side 7 of the printed circuit board 6. In a top view of the upper side 27 of the lower housing part 4, the rib structure 16 can also - in an analogous manner to the support structure 20 - have the geometry of a cross 30 with a 90° rotational symmetry.

According to Figure 1, the printed circuit board 6 is thus sandwiched between the rib structure 16 formed on the lower housing part 4 and the support structure 20 formed on the upper housing part 5. On an upper side 27 of the upper housing part facing away from the printed circuit board 6, an additional printed circuit board 31 is provided on the support structure 20. The additional circuit board 31 comprises electronic logic components 32 for controlling the at least one power transistor 8.

According to Figure 1, at least one electrical power terminal 34 and/or at least one electrical control terminal 35 interface is arranged on the circumferential wall 19.

Figure 5 shows a perspective view of the printed circuit board 6 with the lower housing part 4, in which the underside 26 of the printed circuit board 6 can be seen. Accordingly, in the region of the lateral contact zone 29, a thermally conductive layer 17 may be provided between the printed circuit board 6 and the rib structure 16. The heat conduction conductive layer 17 serves to thermally couple the printed circuit board 6 with the power transistors 8 to the lower housing part 4.

## Claims

1. Control device (1) for an electrical machine,
- having a housing (2) partially surrounding a housing interior (3), comprising a housing lower part (4) made of metal, preferably aluminum, and having a housing upper part (5) made of plastic,
- having a printed circuit board (6) which is arranged in the housing interior (3) between the housing lower part (4) and the housing upper part (5) and on whose upper side (7) facing the housing upper part (5) at least one electrical/electronic power transistor (8) is arranged for supplying the electrical machine with electrical energy, which power transistor generates waste heat during operation,
- wherein a biasing element (10) is arranged between the at least one power transistor (8) and the upper housing part (5), which biases the power transistor (8) against the lower housing part (4) to form a thermal contact.

2. Control device according to claim 1,
**characterized in that**
- at least two, preferably several, power transistors (8) are present,
- a biasing element (10) is provided for each electrical power transistor (8).

3. Control device according to claim 1 or 2,
**characterized in that**
the biasing element (10) comprises or is a leaf spring (11) with a geometry which is U-shaped in profile, a first U-leg (12a) being supported on the upper housing part (5) and a second U-leg (12b) being supported on the power transistor (8).

4. Control device according to one of claims 1 to 3,
**characterized in that**
- the upper housing part (5) is configured as a housing frame (18) with a, preferably annular, circumferential wall (19) and with a support structure (20) of open design on the end face,
- the end-face support structure (20) is open and comprises two strut-like support elements (21a, 21b) which in each case connect two spaced-apart, preferably mutually opposite, circumferential wall sections (22a, 22b, 22c, 22d) of the circumferential wall (19) to one another,
- the at least one biasing element (10), preferably its first U-leg (12a), is supported on one of the support elements (21a, 21b).

5. Control device according to one of the preceding claims,
**characterized in that**
a receptacle (14), preferably a recess (15), is formed for each biasing element (10) on an underside (13) of the upper housing part (5) facing the printed circuit board (6), in which receptacle (14) the biasing element (10) is received at least partially, preferably at least with the first U-limb (12a).

6. Control device according to claim 4 and 5,
**characterized in that**
the receptacle (14) or recess provided on the housing upper part (5) is arranged on the support element (21a, 21b).

7. Control device according to any one of claims 4 to 6,
**characterized in that**
the two support elements (21a, 12b):
- cross each other; or/and that
- are arranged at an angle, preferably at a right angle, to one another; or/and **in that**
- form the geometry of a cross, preferably with a substantially 90° rotational symmetry; or/and that
- the support elements and the circumferential wall are integrally formed on each other.

8. Control device according to one of the preceding claims,
**characterized in that**
on an upper side (27) of the housing upper part facing away from the printed circuit board (6), preferably on the support structure (20) or the support elements (21a, 21b), an additional printed circuit board (31) with at least electronic logic component (32) is arranged for interaction with the at least one power transistor (8).

9. Control device according to any one of the preceding claims,
**characterized in that**
- a rib structure (16) with at least two supporting ribs (28) projecting from the upper side (27) is formed on an upper side (27) of the lower housing part (4) facing the printed circuit board (6),
- the supporting ribs (28) bear against the underside 26 of the printed circuit board at least in a contact zone (29), in which contact zone (29) the at least one power transistor (8) is arranged on the upper side (7) of the printed circuit board (6).

10. Control device according to claim 9,
**characterized in that**
a heat-conducting layer (17) for thermally coupling the printed circuit board (6) with the power transistor (8) to the lower housing part (4) is arranged between the printed circuit board (6) and the rib structure (16) at least in the region of the contact zone (33).

11. Control device according to claim 9 or 10, if referred back to one of claims 4 to 8,
**characterized in that**
the support structure (20) and the rib structure (16) have substantially the same geometric shape in a top view of the housing upper part (5) and the housing lower part (4), respectively.

12. Control device according to any one of claims 9 to 11, when referred back to any one of claims 4 to 8,
**characterized in that**
the printed circuit board (6) is sandwiched between the rib structure (16) formed on the lower housing part (4) and the support structure (20) formed on the upper housing part (5).

13. Control device according to any one of the claims 4 to 12,
**characterized in that**
at least one electrical power terminal (34) and/or at least one electrical control terminal (35) interface is arranged on the circumferential wall (19).

14. Electric machine,
- with a stator and with a rotor rotatable relative to the stator,
- with a control device (1) according to one of the preceding claims for driving the rotor.
